Europäisches Patentamt

European Patent Office

Office européen des brevets

(11) Veröffentlichungsnummer: **0 344 458**

**A1**

(12) **EUROPÄISCHE PATENTANMELDUNG**

(21) Anmeldenummer: **89107430.4**

(22) Anmeldetag: **25.04.89**

(51) Int. Cl.4: **H03H 7/48**

(30) Priorität: **03.11.88 DE 3837282**
**28.05.88 DE 3818216**

(43) Veröffentlichungstag der Anmeldung:
**06.12.89 Patentblatt 89/49**

(84) Benannte Vertragsstaaten:
**DE FR GB IT**

(71) Anmelder: **AEG Olympia Aktiengesellschaft**
**Postfach 960**
**D-2940 Wilhelmshaven(DE)**

(72) Erfinder: **Müssener, Karl-Martin, Dipl.-Ing.**
**Weisestrasse 46**
**D-1000 Berlin 44(DE)**

(74) Vertreter: **Vogl, Leo, Dipl.-Ing.**
**AEG Aktiengesellschaft Theodor-Stern-Kai 1**
**D-6000 Frankfurt am Main 70(DE)**

(54) **Brückenschaltung mit Lastausgleichswiderständen.**

(57) Die Erfindung betrifft eine Brückenschaltung zum rückwirkungsarmen Parallelschalten von beliebig vielen Aus-/Eingängen. Die Aus-/Eingänge ($A_1$, $A_2$, $A_3$) sind sternförmig über jeweils eine bei etwa der Mittenfrequenz der Signale $\lambda/4$-lange Transformationsleitung ($L_1$, $L_2$, $L_3$) an einen gemeinsamen Sternpunkt ($P_4$) angeschlossen. Jeder der Aus-/Eingänge ist jeweils über ein Entkopplungsnetzwerk mit jedem der übrigen Aus-/Eingänge verbunden. Die Entkopplungsnetzwerke bestehen jeweils aus einer $\lambda/4$-langen Kompensationsleitung ($L_{11}$, $L_{22}$, $L_{33}$) und einem hierzu in Reihe geschalteten gekoppelten Leitungspaar ($L_{111}$, $L_{112}$, bzw $L_{221}$, $L_{222}$, bzw $L_{331}$, $L_{332}$) mit $\lambda/4$-Leitungen, wobei zwischen Kompensationsleitung und gekoppeltem Leitungspaar jeweils ein komplexer und einseitig an Masse angeschlossener Lastausgleichswiderstand angeschlossen ist.

FIG. 1

EP 0 344 458 A1

## Brückenschaltung mit Lastausgleichswiderständen

Die Erfindung bezieht sich auf eine Brückenschaltung mit Lastausgleichswiderständen gemäß dem Oberbegriff des Anspruchs 1. Eine solche Brückenschaltung ist beispielsweise in dem Artikel von W. V. Tyminski und A. E. Hylas "A Wide-Band Hybrid Ring für UHF", Proceedings of the I.R.E., Januar 1953, S. 81 - 87 beschrieben. Sie ist wahlweise als Leistungsaddierer, der mehrere gleiche oder verschiedene Teilleistungen zu einer Summenleistung addiert, oder umgekehrt als Leistungsteiler verwendbar, der eine Summenleistung in mehrere gleiche oder verschiedene Teilleistungen aufteilt.

Brückenschaltungen dieser Art werden beispielsweise in der Sendertechnik eingesetzt. So können z. B. mehrere Sender mit einer solchen Brücke parallelgeschaltet werden, um die Sendeleistung insgesamt zu erhöhen oder um eine "aktive Reserve" bilden zu können, die bei Ausfall' eines oder mehrerer Sender die Fortführung des Sendebetriebs mit entsprechend verringerter Leistung gestattet. Mit einer solchen Brücke kann aber auch die von einem Sender kommende Leistung auf mehrere Verbraucher verteilt werden.

Die bekannte Brückenschaltung weist grundsätzlich immer eine gerade Anzahl von Eingängen (beim Betrieb als Leistungsaddierer) bzw. Ausgängen (beim Betrieb als Leistungsteiler) auf. Die Eingänge (Ausgänge) sind paarweise über zwei bei etwa der Mittenfrequenz der Signale λ/4-lange Transformationsleitungen an jeweils einem gemeinsamen Summations-(Teilungs-)Punkt zusammengeschaltet. Außerdem sind die Paare jeweils über ein Entkopplungsnetzwerk verbunden, das aus einer Reihenschaltung aus einer bei etwa der Mittenfrequenz der Signale λ/4-langen Kompensationsleitung und einem gekoppelten Leitungspaar mit bei etwa der Mittenfrequenz λ/4-langen Leitungen sowie einem an dem Verbindungspunkt von Kompensationsleitung und gekoppeltem Leitungspaar angeschlossenen und einseitig an Masse liegenden ohmschen Lastausgleichswiderstand besteht.

Die Summations-(Teilungs-)Punkte der einzelnen Eingangs-(Ausgangs-)paare wiederum dienen in einer nächsten Stufe der Brückenschaltung als Eingänge (Ausgänge), die in gleicher Weise wie zuvor beschrieben wieder zu Paaren zusammengeschaltet werden, die jeweils mit einem gleichartigen Entkopplungsnetzwerk voneinander entkoppelt werden.

Durch Hintereinanderschalten mehrerer solcher Stufen entsteht auf diese Art und Weise eine Brückenschaltung mit baumartiger Struktur, die jedoch, wie weiter oben erwähnt, immer nur eine gerade Anzahl von Eingängen (Ausgängen) zuläßt (vgl. insbesondere Fig. 8 in dem Artikel von Tyminski und Hylas).

Beispiele anderer bekannter Brückenschaltungen, wie die nach Schering oder Maxwell-Wien bzw. der 3 dB-Koppler aus zwei bei der Mittenfrequenz λ/4-langen Leitungen usw., sind im Taschenbuch der Hochfrequenztechnik (Springer-Verlag, Berlin, 1968, 3. Auflage) auf den Seiten 1441 bis 1451 beschrieben. Bei diesen Brückenschaltungen werden beim Betrieb als Leistungsaddierer bzw. Leistungsteiler die Eingänge bzw. Ausgänge ebenfalls mit Hilfe von ohmschen Lastausgleichswiderständen entkoppelt, die symmetrisch oder asymmetrisch an die Eingänge bzw. Ausgänge einer solchen Brückenschaltung angeschlossen sind. Damit ist in der Theorie ein rückwirkungsfreier, in der Praxis ein rückwirkungsarmer Betrieb mit einem in der Regel tolerierbaren Rückwirkungsgrad bei der Mittenfrequenz und gleichen Teilleistungen möglich. Weichen jedoch die Frequenzen von der Mittenfrequenz ab und/oder treten verschieden hohe Teilleistungen auf, treten unerwünschte und häufig nicht mehr tolerierbare Rückwirkungen auf, die im allgemeinen um so größer sind, je mehr die Frequenzen von der Mittenfrequenz abweichen bzw. je unterschiedlicher die Teilleistungen in ihrer Höhe sind.

Der Erfindung liegt die Aufgabe zugrunde, eine Brückenschaltung der eingangs genannten Art zu schaffen, die mit einer beliebigen Anzahl von Eingängen (Ausgängen) aufgebaut werden kann und die darüber hinaus beim Betrieb als Leistungsaddierer bzw. Leistungsteiler in einem möglichst großen Frequenzbereich (der z. B. (eine Oktave umfassen kann) und/oder bei verschieden hohen Teilleistungen (u. a. auch bei Ausfall eines oder mehrerer der angeschlossenen Signalkanäle) eine möglichst hohe gegenseitige Entkopplung der Eingänge bzw. Ausgänge aufweist, so daß ein möglichst rückwirkungsarmer Betrieb mit einem tolerierbaren Rückwirkungsgrad unter den angegebenen Bedingungen möglich ist.

Die erfindungsgemäße Lösung der Aufgabe ist im Patentanspruch 1 beschrieben. Die übrigen Ansprüche enthalten vorteilhafte Aus- und Weiterbildungen der Erfindung sowie eine bevorzugte Anwendung der Erfindung.

Die erfindungsgemäße Lösung besteht darin, die Ausgänge (Eingänge) einer solchen Brückenschaltung über jeweils eine bei etwa der Mittenfrequenz der Signale λ/4-lange Transformationsleitung direkt an einen für alle Ausgänge (Eingänge) gemeinsamen Teilungs-(Summations-)Punkt anzuschließen und zur gegenseitigen Entkopplung jeden der einzelnen Ausgänge (Eingänge) über jeweils

2

ein Entkopplungsnetzwerk mit jedem der übrigen Ausgänge (Eingänge) zu verbinden, wobei in bevorzugten Ausführungsformen der Erfindung sich das erfindungsgemäße Entkopplungsnetzwerk von dem bekannten Entkopplungsnetzwerk dadurch unterscheidet, daß die Lastausgleichswiderstände im erfindungsgemäßen Entkopplungsnetzwerk komplex ausgeführt sind.

Die Vorteile der erfindungsgemäßen Lösung bestehen im wesentlichen darin, daß mit relativ wenig Aufwand für eine beliebige Anzahl von Ausgängen (Eingängen) zum einen durch die Entkopplungsnetzwerke die Transformationseigenschaften der mindestens zwei bei etwa der Mittenfrequenz $\lambda/4$-langen Transformationsleitungen der Brückenschaltung insbesondere für Frequenzen verbessert werden, die von der Mittenfrequenz abweichen, und zum anderen durch den komplexen Lastausgleichswiderstand eine hohe gegenseitige Entkopplung der Ein- bzw. Ausgänge der Brückenschaltung erzielt wird.

Im folgenden soll die Erfindung anhand der Figuren näher erläutert werden. Es zeigen:

FIG. 1 ein bevorzugtes Auführungsbeispiel der erfindungsgemäßen Brückenschaltung mit drei Ausgängen (Eingängen);

FIG. 2 ein in Koaxialleitungstechnik ausgeführtes Ausführungsbeispiel eines gekoppelten Leitungspaares des Entkopplungsnetzwerkes.

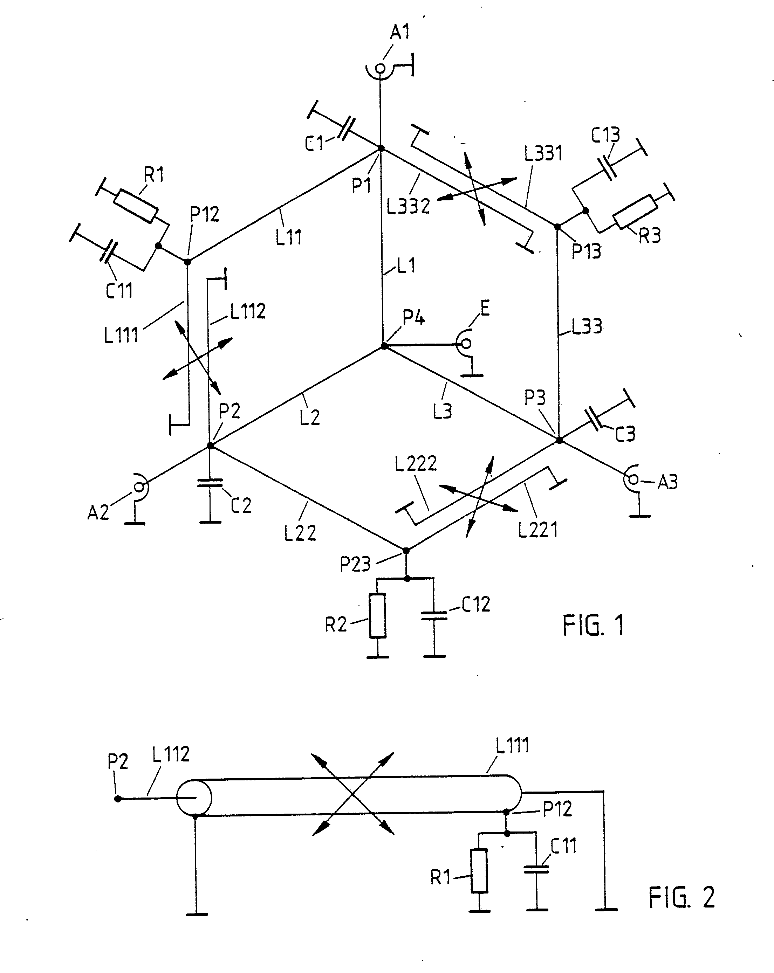

Die in FIG. 1 gezeigte erfindungsgemäße Brückenschaltung weist drei Ausgänge (Eingänge) A1, A2, A3 auf, die an den Punkten P1, P2, P3 jeweils mit einer bei etwa der Mittenfrequenz der Signale $\lambda/4$-langen Transformationsleitung L1, L2, L3 mit dem gemeinsamen Teilungs-(Summations-)Punkt P4 verbunden sind, der wiederum mit dem Teilereingang (Addiererausgang) E verbunden ist.

Der Wellenwiderstand der Transformationsleitungen L1 - L3 beträgt jeweils $\sqrt{3}\ Z_L$. Mit ihnen werden beispielsweise Lastwiderstände von 50 Q zunächst auf 150 Q herauftransformiert und anschließend durch die Sternschaltung (Parallelschaltung) der Leitung am Teilungs-(Summations-)Punkt wieder auf 50 Q herabtransformiert, so daß theoretisch eine ideale Anpassung durch die Brückenschaltung bewirkt wird.

An den Punkten P1 - P3 sind außerdem Entkopplungsnetzwerke angeschlossen, die jeweils aus einer Reihenschaltung aus einer Kompensationsleitung L11 bzw. L22 bzw. L33 und einem gekoppelten Leitungspaar L111, L112 bzw. L221, L222 bzw. L331, L332 bestehen, wobei an dem Verbindungspunkt P12 bzw. P23 bzw. P31 von Kompensationsleitung und gekoppeltem Leitungspaar jeweils ein komplexer Lastausgleichswiderstand angeschlossen ist, der einseitig an Masse liegt. In dem Ausführungsbeispiel besteht ein solcher Lastausgleichswiderstand aus einer Parallelschaltung von ohmschem Widerstand R1 bzw. R2 bzw. R3 und Kondensator C11 bzw. C12 bzw. C13. Die gekoppelten Leitungspaare bestehen jeweils aus zwei Leitungen L111, L112 bzw. L221, L222 bzw. L331, L332, die jeweils mit ihrem freien Ende an Masse angeschlossen sind.

An den Punkten P1 - P3 ist zusätzlich jeweils ein einseitig an Masse angeschlossener Kondensator C1 bzw. C2 bzw. C3 angeschlossen.

Die hier beschriebene Brückenschaltung eignet sich insbesondere für den Einsatz in einem modernen Transistorsender. Mit den heute verfügbaren Bauelementen erfordert beispielsweise die Erzeugung einer Sender-Ausgangsleistung von 1 kW die Parallelschaltung von drei Verstärkermodulen, die mit Hilfe der erfindungsgemäßen Brückenschaltung gemäß FIG. 1 sehr leicht zu realisieren ist, indem jeweils eine solche Brückenschaltung an die Eingänge bzw. Ausgänge der Verstärkermoduln angeschlossen wird und damit die Anpassung und gegenseitige Entkopplung der Moduln sicherstellen.

Der wesentliche Bestandteil der Brückenschaltung in FIG. 1 sind die sternförmig angeordneten Transformationsleitungen L1 - L3, die im Leistungsteilerbetrieb eine im Teilungs-(Summations-)Punkt oder kurz "Sternpunkt" P4 eingespeiste Welle mit jeweils gleichen Amplituden und Phasen auf die drei Ausgänge A1 - A3 aufteilen. Längen und Wellenwiderstände dieser Leitungen L1 - L3 sind für möglichst breitbandige Anpassung am Sternpunkt P4 bemessen. Die übrigen Bestandteile der Brückenschaltung, also die Kompensationsleitungen L11, L22, L33, die gekoppelten Leitungspaare L111, L112; L221, L222; L331, L332, die Lastausgleichswiderstände R1, C11; R2, C12; R3, C13 sowie die Kondensatoren C1 - C3 bewirken eine hohe gegenseitige Entkopplung der Augänge S1 - S3.

Die aus den gekoppelten Leitungspaaren, den Lastausgleichswiderständen und den Kompensationsleitungen bestehende Schaltungsanordnung kompensiert die über den Sternpunkt P4 führenden Signalwege (z. B. von A2 über L2 und L3 nach A3), indem diese mit invertierter Phase nachgebildet und parallelgeschaltet werden.

Ein Leistungsübergang zwischen den Ausgängen und eine gegen seitige Beeinflussung der Verstärker werden dadurch vermieden.

Die Phaseninvertierung wird mit Hilfe der gekoppelten Leitungspaare (z. B. L111, L112) erreicht. Auf diesen Leitungspaaren treten Gegentakt- und Gleichtaktwellen auf, die aufgrund des Leitungsaufbaus unterschiedliche Ausbreitungsgeschwindigkeiten aufweisen. Dadurch treten an den Leitungsenden unerwünschte Blindleitwerte auf. die durch kleine Zusatzkapazitäten C1 bis C3 bzw. durch die Kapazitäten C11 bis C13 der komplex ausgebildeten Lastausgleichswiderstände weitgehend unwirksam gemacht werden.

Die Kompensationsleitungen L11, L22 und L33 sorgen für gleiche Leitungslängen auf den zu kompensierenden Signalwegen, wodurch eine breitbandige Entkopplung der Ausgänge A1 - A3 erreicht wird. Ferner wird mit diesen Leitungen die Frequenzabhängigkeit der drei Transformationsleitungen teilweise kompensiert, wodurch die nutzbare Bandbreite des Leistungsteilers wesentlich erhöht wird.

Die erwähnte Nachbildung der Signalwege über den Sternpunkt P4 erfordert schließlich den Einbau der ohmschen Lastausgleichswiderstände R1 bis R3. Diese nehmen bei symmetrischer Belastung des Leistungsteilers keine Leistung auf.

Bei Betrieb der Schaltung als Leistungsaddierer werden die ohmschen Widerstände R1 - R3 bei Ausfall eines der drei Verstärker des Senders mit 1/3 der Leistung eines solchen Einzelverstärkers belastet.

Der Leistungsteiler wird vorzugsweise als gedruckte Schaltung auf einem verlustarmen Kunststoffsubstrat als Dielektrikum realisiert. Dabei werden die gekoppelten Leitungspaare vorzugsweise als symmetrische Bandleitung, die übrigen Leitungen vorzugsweise als Mikrostreifenleitung ausgeführt.

Die Leitungen der gekoppelten Leitungspaare können dabei entweder beide auf der Ober- oder Unterseite des Dielektrikums mit konstantem Abstand voneinander verlaufen oder jeweils die eine (z. B. L111 bzw. L222 bzw. L331) auf der Unterseite des Dielektrikums und die andere (L112 bzw. L222 bzw. L332) genau oder versetzt über ihr auf der Oberseite des Dielektrikums.

Die wesentlichen Vorteile der erfindungsgemäßen Brückenschaltung bestehen darin, daß mit ihr eine kompakte und leicht herzustellende Brückenschaltung für beliebig viele Ausgänge (Eingänge) zur Verfügung steht, die zudem über einen großen Frequenzbereich selbst bei wesentlich hohen Teilleistungen oder Ausfall einzelner Teilleistungen eine sehr hohe gegenseitige Entkopplung der Ausgänge (Eingänge) gewährleistet, so daß ein rückwirkungsarmer Betrieb selbst unter ungünstigen Bedingungen möglich ist.

Es versteht sich, daß die Erfindung mit fachmännischem Wissen und Können aus- und weitergebildet werden kann, ohne daß dies hier an dieser Stelle näher erläutert werden müßte.

So ist es z. B. möglich, die Transformationsleitungen jeweils aus mindestens zwei in Kette geschalteten und bei etwa der Mittenfrequenz $\lambda/4$-langen Leitungsstücken zusammenzusetzen.

Weiterhin ist es denkbar, die gekoppelten Leitungspaare jeweils mit einer umgepolten Koaxialleitung zu realisieren, bei der gemäß FIG. 2 der einseitig an Masse angeschlossene Innenleiter als die eine Leitung, z. B. L112, und der Außenleiter, der an seinem einen Ende an Masse und an seinem anderen Ende an dem komplexen Lastausgleichswiderstand R1, C11 angeschlossen ist, als die andere Leitung L111 dient.

Schließlich ist es möglich, zur besseren Kompensation der Transformationsleitungen einen Reihenschwingkreis am Sternpunkt der Brückenschaltung anzuschließen, dessen Resonanzfrequenz mit der Mittenfrequenz der Signale in etwa übereinstimmt.

Die Schaltung gemäß FIG. 1 eignet sich insbesondere für den VHF- und UHF-Bereich. Jedoch erstreckt sich das Anwendungsgebiet der Erfindung nicht nur auf die Sendertechnik, vielmehr kann sie allgemein in vielen anderen Gebieten, wie z. B. in der Meßtechnik, in der Antennentechnik oder bei Filtern und Phasenschiebern usw., eingesetzt werden.

## Ansprüche

1. Brückenschaltung mit Lastausgleichswiderständen zum rückwirkungsarmen Parallelschalten von mindestens zwei Ausgängen (Eingängen) für Signale gleicher oder unterschiedlicher Leistung und/oder Frequenz, welche zum einen alle mit einem gemeinsamen Teilungs-(Summations-)Punkt verbunden sind und welche zum anderen über Entkopplungsnetzwerke paarweise miteinander verbunden sind, welche Entkopplungsnetzwerke jeweils aus einer Reihenschaltung aus einer bei etwa der Mittenfrequenz der Signale $\lambda/4$-langen Kompensationsleitung und einem gekoppelten Leitungspaar mit bei etwa der Mittenfrequenz $\lambda/4$-langen Leitungen sowie einem an dem Verbindungspunkt von Kompensationsleitung und gekoppeltem Leitungspaar angeschlossenen und einseitig an Masse liegenden Lastausgleichswiderstand bestehen, dadurch gekennzeichnet, - daß die Ausgänge (Eingänge) (A1, A2, A3) sternförmig über jeweils eine bei etwa der Mittenfrequenz $\lambda/4$-lange Transformatorleitung (L1, L2, L3) an den gemeinsamen Teilungs-(Summations-)Punkt (P4) angeschlossen sind,

- daß jedes mögliche Paar von Ausgängen (Eingängen) (A1, A2; A2, A3; A3, A1) jeweils über ein Entkopplungsnetz werk (L11, R1, C11, L111, L112; L22, R2, C12, L221, L222; L33, R3, C13, L331, L332) miteinander verbunden ist (FIG. 1).

2. Brückenschaltung nach Anspruch 1, dadurch gekennzeichnet, daß die Lastausgleichswiderstände (R1, C11; R2, C12; R3, C13) komplex sind.

3. Brückenschaltung nach Anspruch 2, dadurch gekennzeichnet, daß die Lastausgleichswiderstände jeweils aus einer Parallelschaltung von ohmschem Widerstand ($R_1$; $R_2$; $R_3$) und Kondensator ($C11$; $C12$; $C13$) bestehen.

4. Brückenschaltung nach einem der Ansprüche 1 bis 3, dadurch gekennzeichnet, daß die Leitungen ($L111$, $L112$; $L221$, $L222$; $L331$, $L332$) der gekoppelten Leitungspaare mit ihren freien Enden an Masse angeschlossen sind.

5. Brückenschaltung nach einem der Ansprüche 1 bis 4, dadurch gekennzeichnet, daß die Transformationsleitungen ($L1$, $L2$, $L3$) und/oder die Kompensationsleitungen ($L11$, $L22$, $L33$) und/oder die gekoppelten Leitungspaare ($L111$, $L112$; $L221$, $L222$; $L331$, $L332$) als gedruckte Schaltung ausgeführt sind.

6. Brückenschaltung nach Anspruch 5, dadurch gekennzeichnet, daß die gekoppelten Leitungspaare ($L111$, $L112$; $L221$, $L222$; $L331$, $L332$) als symmetrische Bandleitungen ausgeführt sind mit jeweils einer Leitung ($L111$, $L221$, $L331$) auf der Unterseite eines Dielektrikums und einer Leitung ($L112$, $L222$, $L332$) auf der Oberseite des Dielektrikums.

7. Brückenschaltung nach Anspruch 5, dadurch gekennzeichnet, daß die gekoppelten Leitungspaare ($L111$, $L112$; $L221$, $L222$; $L331$, $L332$) als symmetrische Bandleitungen ausgeführt sind mit jeweils beiden Leitungen auf der Ober- oder Unterseite des Dielektrikums.

8. Brückenschaltung nach Anspruch 5, dadurch gekennzeichnet, daß die Transformationsleitungen ($L1$, $L2$, $L3$) und die Kompensationsleitungen ($L11$, $L22$, $L33$) als Mikrostreifenleitungen ausgeführt sind.

9. Brückenschaltung nach Anspruch 5, dadurch gekennzeichnet daß die Transformationsleitungen ($L1$, $L2$, $L3$) jeweils aus mindestens zwei in Kette geschalteten und bei etwa der Mittenfrequenz $\lambda/4$-langen Leitungsstücken bestehen.

10. Brückenschaltung nach einem der Ansprüche 1 bis 4, dadurch gekennzeichnet, daß die gekoppelten Leitungspaare ($L111$, $L112$; $L221$, $L222$; $L331$, $L332$) jeweils mit einer umgepolten Koaxialleitung realisiert sind mit dem Innenleiter als der einen Leitung ($L111$; $L221$; $L331$) und dem Außenmantel als der anderen Leitung ($L112$; $L222$; $L332$) (FIG. 2).

11. Brückenschaltung nach einem der Ansprüche 1 bis 10, dadurch gekennzeichnet, daß an den Ankopplungspunkten ($P1$, $P2$, $P3$) der Eingänge (Ausgänge) ($A1$; $A2$; $A3$) an die Transformationsleitungen ($L1$; $L2$; $L3$) und die Kompensationsleitungen ($L11$; $L22$; $L33$) jeweils ein einseitig an Masse angeschlossener Kondensator ($C1$; $C2$; $C3$) angeschlossen ist.

12. Brückenschaltung nach einem der Ansprüche 1 bis 11, dadurch gekennzeichnet, daß an den Teilungs-(Summations-)Punkt ($P4$) ein Reihenschwingkreis mit Resonanzfrequenz etwa bei der Mittenfrequenz angeschlossen ist.

13. Brückenschaltung nach einem der Ansprüche 1 bis 12, dadurch gekennzeichnet, daß die Brückenschaltung eine ungerade Anzahl von Eingängen (Ausgängen) ($A1$, $A2$, $A3$) aufweist.

14. Brückenschaltung nach Anspruch 13, dadurch gekennzeichnet, daß die Brückenschaltung drei Eingänge (Ausgänge) ($A1$, $A2$, $A3$) aufweist.

15. Brückenschaltung nach einem der Ansprüche 1 bis 14, gekennzeichnet durch die Anwendung als Leistungsaddierer oder -teiler in einem modular aufgebauten Sender.

FIG. 1

FIG. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | TELECOMMUNICATIONS AND RADIO ENGINEERING, Band 27/28, Nr. 9, September 1973, Seiten 94-98, Washington, US; V.A. PYLAKIN: "Design of power dividers with any number of decoupled outputs" * Insgesamt * --- | 1,9,13, 14 | H 03 H 7/48 |
| Y | DE-B-1 222 556 (FUBA) * Insgesamt * | 1,9,13, 14 | |
| A | --- | 4,10 | |
| A | MICROWAVE JOURNAL, Band 22, Nr. 12, Dezember 1979, Seiten 51-56, Dedham, GB; H. HOWE, Jr.: "Simplified design of high power, N-way, in-phase power divider/combiners" * Figur 2; Seite 52, Spalte 2 * --- | 5,8 | |
| A | DE-B-1 150 124 (TELEFUNKEN) * Figur 1; Spalte 4, Zelen 39-62; Spalte 5, Zeilen 31-55 * --- | 2,13,14 | RECHERCHIERTE SACHGEBIETE (Int. Cl.4) |
| E,X | EP-A-0 277 501 (LICENTIA) * Insgesamt * ----- | 1-3 | H 03 H |

Der vorliegende Recherchenbericht wurde für alle Patentansprüche erstellt

| Recherchenort | Abschlußdatum der Recherche | Prüfer |
|---|---|---|
| DEN HAAG | 06-09-1989 | COPPIETERS C. |